# EUROPEAN PATENT APPLICATION

(11) **EP 4 711 492 A1**
(43) Date of publication of application: **18.03.2026**
(21) Application number: 25201013.7
(22) Date of filing: 09.09.2025
(51) Int. Cl.: C23C 16/32, C23C 16/44

(54) **PHOTON-ASSISTED CHEMICAL ETCHING OF SILICON CARBIDE FILMS FROM REACTION CHAMBER PARTS**

(30) Priority: 12.09.2024 IT 202400020284
(71) Applicant: LPE S.p.A., 20021 Baranzate (MI) (IT)
(72) Inventor: FATUZZO, Claudia Giuseppina, Catania (IT); VALENTE, Gianluca, Milano (IT)
(74) Representative: Buzzi, Notaro & Antonielli d'Oulx S.p.A.

(57) **Abstract**

The present invention relates to a method for etching a silicon carbide film from one or more parts of a reaction chamber suitable for the deposition of silicon carbide layers on a substrate. The method comprises the steps of: (i) providing a silicon carbide film on one or more parts of a reaction chamber of a reactor for deposition silicon carbide; (ii) executing at least one cycle of an etching process. The etching process includes at least one cycle of a UV-photon assisted chemical etching. The present invention further relates to a reactor adapted to execute said method.

## Description

### FIELD OF INVENTION

The present invention relates to the field of epitaxial deposition of semiconductor films on substrates; in particular to a method and to a reactor adapted to execute a photon-assisted chemical etching of silicon carbide from reactor parts.

Additionally, though not exclusively, the present invention relates to the field of the deposition of silicon carbide films on a semiconductor substrate in a hot-wall, crossflow homoepitaxial or heteroepitaxial reactor.

### BACKGROUND OF THE DISCLOSURE

Semiconductor layers made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface features, making them suitable for the manufacturing of complex microprocessors and memory devices.

Typically, the reaction chamber is heated to a desired temperature before deposition, and then the temperature is maintained substantially constant throughout the deposition process.

In case of epitaxial reactors for the deposition of silicon carbide, the temperatures within the cavity of the chamber may be in the 1300 - 1700 °C range. These temperatures may be reached in many ways and the chamber may be of the "hot-wall" or "cool-wall" type. In the former non-limiting example, the walls of the reaction chamber, as well as the enclosed cavity, typically reach high deposition temperatures. These parts may be effectively heated via induction means. In this case, the reaction chamber may comprise one or more structural parts, such as one or more walls, made of a susceptive material, for example graphite.

The reaction chamber may additionally comprise susceptive functional parts, such as graphite substrate holders, rings, and upstream and downstream cover elements.

Both functional and structural susceptive parts may be provided with suitable coatings to protect the chamber from contamination and increase its lifetime.

The reaction chamber may additionally comprise non susceptive parts, such as smooth polycrystalline SiC elements, which may be employed in one or more structural parts, such as the lateral walls.

During an epitaxial deposition process, one or more semiconductor layers grow in a controlled fashion on a rotating substrate. However, undesired semiconductor films may also simultaneously grow on other areas of the reaction chamber.

Indeed, during the epitaxial deposition on a substrate of monocrystalline silicon carbide, for instance 3C, 4H or 6H silicon carbide polytypes, users observe uncontrolled silicon carbide build-up on both structural and functional parts of the reaction chamber. It is noted that this undesired silicon carbide build-up is very difficult to remove because of the hardness of the material.

Silicon carbide build-up may comprise polycrystalline and/or amorphous silicon carbide. Typically, it is a mixture of both polycrystalline and amorphous silicon carbide. The latter may compose up to 20 - 60% of the total, as can be observed in XRD measurements, though the relative ratio may vary.

The above parasitic phenomenon is particularly relevant in hot-wall reactors, where it is prevalently impacting the upstream end of the chamber (i.e., where the precursor gases enter the reaction chamber), as well as the elements surrounding the substrate or in contact with the same.

It is noted that undesired SiC buildup does not occur only on bare surfaces of the reaction chamber but also on those parts that are preventively coated.

Indeed, some or all parts of the reaction chamber are typically provided with a TaC coating to protect the graphite surfaces during cleaning operations. Alternatively, a thin coating of SiC is used to seal the exposed porous graphite surfaces to avoid chamber contamination. In this case, the SiC coating used on the graphite parts is in polycrystalline form, typically with a surface roughness below 6,3 µm Ra, more typically below 1 µm Ra.

It has been observed that the parasitic deposition of SiC films on reaction chamber parts often results in the rapid growth of cauliflower-like, porous, dendritic-like structures, which eventually affect the quality of the deposited layers on the semiconductor substrates. These parasitic films have an uneven appearance, with macroscopic rugosity.

Without committing to a specific theory, it is believed that geometric irregularities in the early formation stage of the SiC parasitic film function as "seed" to promote fractal-like growth in preferential directions, resulting in a highly uneven film structure.

In order to prevent the negative effects of parasitic films on the deposition process, the reaction chamber is subject to frequent Preventive Maintenance (PM) operations, for instance after every 100 µm to 2 mm of total epitaxial layers deposited.

During PM, the machine is cooled and purged, and some or all affected parts are manually removed from the chamber for mechanical cleaning, disposal and/or substitution.

PM operations negatively impact the productivity of the reactor, thereby heavily affecting the economics of the epitaxial deposition process.

Indeed, PM operations may cause up to 8 - 12 hours of reactor downtime every few days of use.

Other techniques, such as in-situ or ex-situ chemical etching processes to remove parasitic build-up are known and used in Si reactors, to remove undesired Si deposits. These methods allow more reproducible results than their mechanical cleaning counterparts. Additionally, in-situ etching processes can be performed without the need to open and access the reaction chamber, advantageously reducing reactor downtime and streamlining operations.

However, silicon carbide exhibits very different chemical and physical properties compared to silicon. The material, characterized by a 9-10 Mohs hardness, is difficult to attack via chemical means without eventually damaging the concerned reactor parts and/or introducing potential contaminants into the chamber. Additionally, the silicon and carbon components of SiC behave differently when exposed to chemical attack.

While methods for etching SiC have been disclosed in the art, these methods typically discuss the removal of a few top layers of orderly SiC from bulk SiC pieces, such as described in US20140030892A1 and US20060001028A1. The chemical etching of SiC in these instances takes place in the absence of an underlying part (of potentially different composition) that may be damaged in the process. These processes typically remove only a few microns of SiC.

The methods disclosed in US20140030892A1 and US20060001028A1 provide a wide range of process conditions. They address specific surface defects of the SiC piece concerned, respectively: warpage of monocrystalline SiC substrates and surface cracks of SiC substrate holders. These methods do not address the removal of disorderly parasitic SiC deposits without detriment to the affected reaction chamber parts.

It is therefore desirable to provide a method for etching polycrystalline-amorphous SiC parasitic build-up from concerned parts of a reaction chamber without damaging said parts.

It is also desirable to provide a method for etching polycrystalline/amorphous SiC parasitic build-up that may be performed *in-situ,* i.e., directly in the reaction chamber without opening the latter and/or extracting it from the reactor.

Additionally, it would be desirable to provide a new reactor adapted to execute the above-mentioned method. Furthermore, it would be desirable to provide a reactor configured to execute said method in an automated fashion.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide a new method for etching polycrystalline/amorphous SiC parasitic build-up from parts of a reaction chamber without damaging said parts. It is a further object of the present invention to provide a new method for etching Polycrystalline/amorphous SiC parasitic build-up that may be performed *in-situ.*

It is a further object of the present invention to provide a new reactor adapted to execute the above new method, optionally in an automated fashion.

The main objectives hereinbefore described are achieved through the invention recited in the appended claims, which constitute an integral part of the present description.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 is a block diagram, which schematically illustrates the method according to an embodiment of the present invention.
FIG. 2 is a block diagram, which schematically illustrates the method according to an embodiment of the present invention.
FIG. 3 is a block diagram, which schematically illustrates the method according to an embodiment of the present invention.
FIG. 4 is a block diagram, schematically illustrating particulars of FIG. 3.
FIG. 5 schematically illustrates a longitudinal view of a reaction chamber according to an embodiment of the present invention.
FIG. 6 schematically illustrates a longitudinal view of a reaction chamber according to an embodiment of the present invention.
FIG. 7 schematically illustrates a transverse view of a reaction chamber according to an embodiment of the present invention.
FIG. 8 provides a simplified scheme of a reactor layout according to an embodiment of the present invention.
FIG. 9 provides a grayscale picture of a parasitic silicon carbide film deposited on a spare graphite part of a hot wall reaction chamber for the deposition of silicon carbide.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

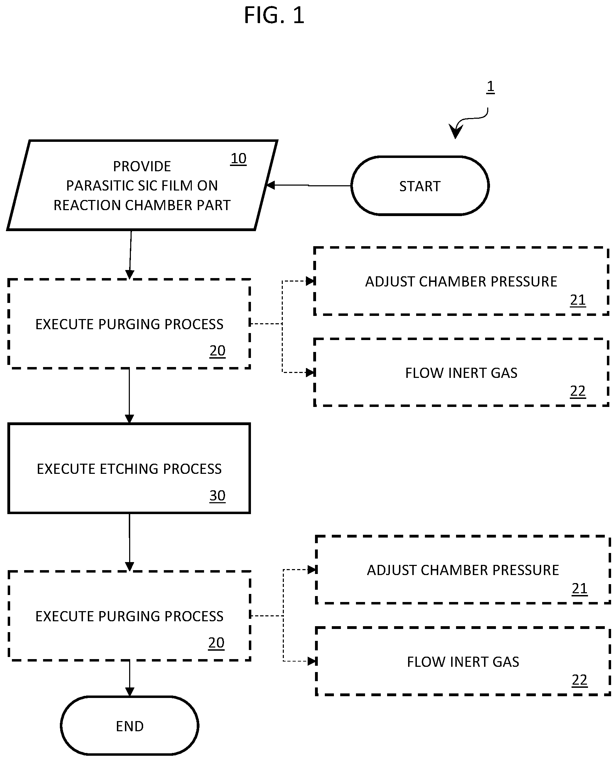

In FIG. 1 to FIG. 4, optional steps and sub-steps are distinguished from essential steps and sub-steps by the use of a dashed line instead of a solid line.

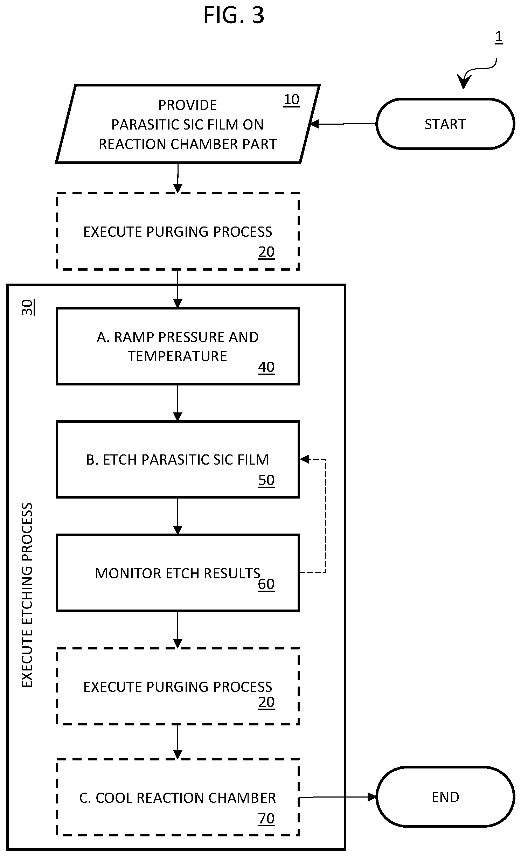

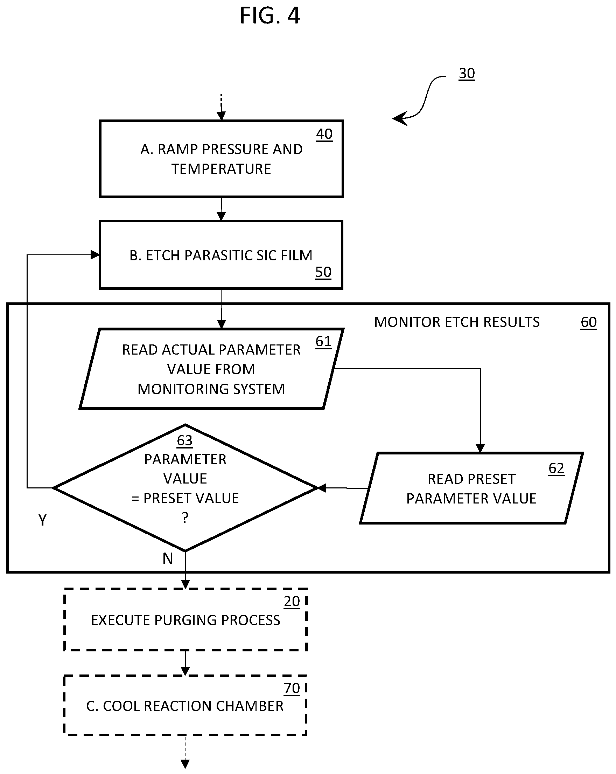

FIG. 4 provides details on the execution of the etching process depicted in FIG. 3; in particular on how block 60 of FIG. 3 operates in relation to blocks 50 and **20** thereof.

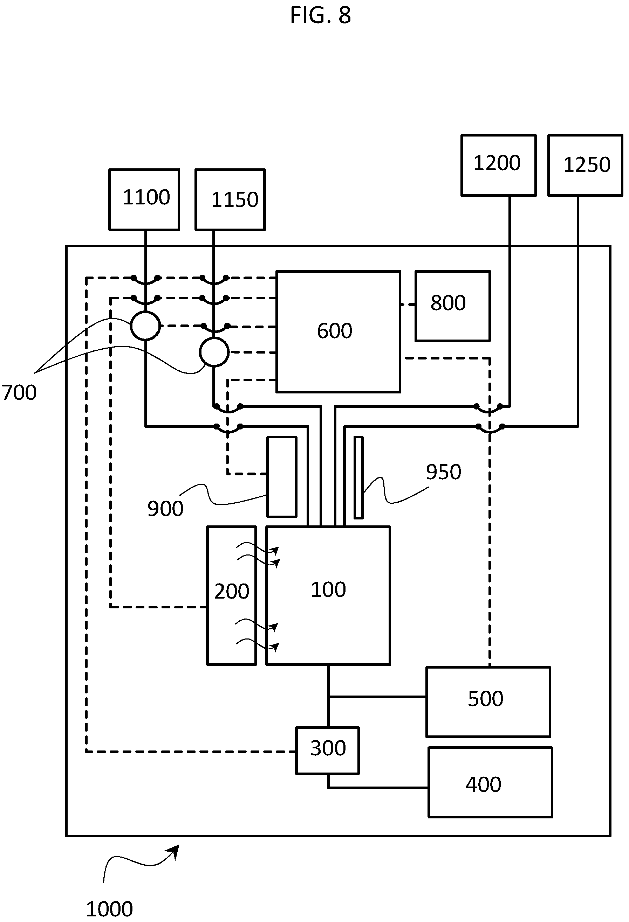

In FIG. 8 all connections of digital signals are indicated as dashed lines. Physical connections are indicated by solid lines.

It will be appreciated that elements in the figures are illustrated for simplicity and clarity. In particular some elements may have been omitted or may have not been drawn to scale. For example, the dimensions of some of the elements in the figures may be exaggerated relative to other elements to help improve understanding of illustrated embodiments of the present disclosure.

Under a first aspect, the present invention relates to a method 1 for etching a SiC film from one or more parts of a reaction chamber 100 of a reactor 1000, where the latter is adapted for the deposition of monocrystalline SiC layers on a substrate.

By "etching" it is meant chemical etching.

The reactor comprises at least one light source adapted to emit light in the 310-370 nm range, i.e., its emission spectrum features one or more wavelengths in said UV range, without necessarily covering the entire spectral range.

Examples of light sources include UV lamps, LEDs, or lasers or combinations thereof.

The method 1 comprises several steps, or stages, discussed below. The first step (i) of the invention is set forth in block 10 of FIG. 1 to FIG. 3.

Step (i) is to provide a SiC film on one or more parts of a reaction chamber of a reactor for the deposition silicon carbide.

Step (ii) is to execute at least one cycle of an etching process as set forth in block 30, i.e., a process for the chemical cleaning/removal of the SiC parasitic deposits provided in step (i).

The etching process comprises the consecutive steps, or phases, of: A) ramping the reaction chamber to preset etching process conditions; B) etching the silicon carbide film; and optionally, C) performing a cooling step.

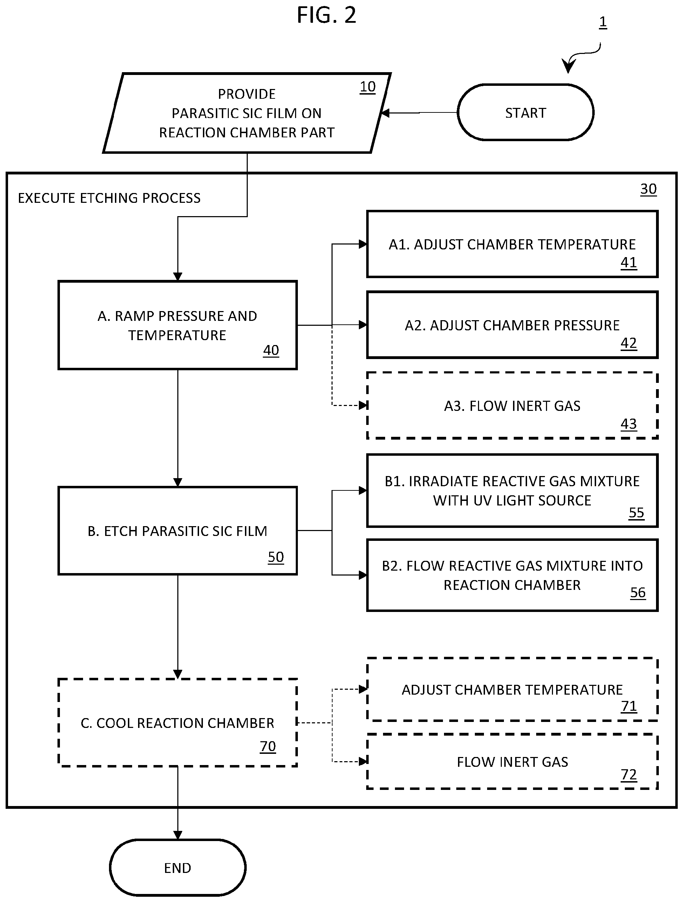

Steps A), B) and C) are respectively set forth in blocks 40, **50** and **70** of FIG. 2 to FIG. 3.

Specifically, step A) comprises the following sub-steps:
A1) ramping the temperature of the reaction chamber to 800 - 1450 °C, preferably to 800 - 1100 °C;
A2) ramping the pressure of the reaction chamber to 50 - 1000 mbar, preferably 150 - 700 mbar;
A3) optionally flowing an inert gas into the reaction chamber, which may help to reach and maintain the desired temperature and pressure conditions.

All sub-steps A1-A3 above (respectively set out in blocks 41, **42,** and **43** of FIG. 2), whether mandatory or optional, may be performed in any order, including simultaneously.

The preset etching process conditions of step A comprise or consist of the temperature and pressure conditions set out in sub-steps A1 and A2.

Step A) is performed by gradually adjusting pressure and temperature conditions from a starting value to the desired process value, thereby protecting the reaction chamber from the undesired effects of abrupt changes, which may cause stress and damage to mechanical parts, and/or cause lack of uniformity of process conditions inside the reaction chamber.

Once the reaction chamber has reached the desired temperature and pressure settings, the actual etching of the SiC parasitic film can take place according to step B).

Step B) comprises the following sub-steps:
B1) exposing a first reactive composition to the light source above described (block 55); and
B2) delivering the first reactive composition into the reaction chamber (block 56).

The first reactive composition comprises one or more reactive gases, i.e., gases suitable to react with Si and/or C for etching purposes. In particular the first reactive composition comprises at least a first reactive gas, such as a halogen molecule or a halogen compound.

Preferably, the halogen molecule or halogen compound is selected with a purity equal to or greater than 99.990%, even more preferably with a purity equal to or greater than 99.998%.

The first reactive composition also comprises a carrier gas; which is preferably an inert gas. For example, the carrier gas may be nitrogen, or, preferably, helium or argon to avoid contamination of the chamber. The carrier gas may advantageously be used to tailor and control the concentration and distribution of reactive gases in the chamber.

The halogen or halogen compound may be delivered in the reaction chamber in a molecular, radical, and/or ionized state, such as, but not limited to, a plasma state. In a non-limiting example, radicals and/or ions of the first reactive gas may be formed from molecular halogen or halogen compounds inside the reaction chamber, by virtue of the temperature and pressure conditions inside the chamber, and/or under an RF alternating electric field. Alternatively, radicals and/or ions of the first reactive gas may be formed immediately outside the reaction chamber, under specific conditions of temperature, pressure, illumination, and/or electric field.

It is noted that during sub-step B2) of the etching process, because of the pressure and temperature conditions inside the reaction chamber, the halogen molecule or halogen compound forms radicals and/or ions, which attack the SiC film thereby creating by-products of the etching process. These by-products are then discharged out of the reaction chamber.

Furthermore, it is noted that etching products for carbon etching are stable below 1000°C. To improve the etching process, the first reactive gas can be made more reactive by enhancing its dissociation into radicals. In this way the reaction can be conducted at lower temperature, thus allowing faster etch rate and permitting Carbon removal equal to Silicon removal.

Sub-step B1) favors the dissociation of the first reactive gas into its radicals before the first reactive composition enters the reaction chamber for sub-step B2).

Under an embodiment, the light source has at least one emission peak overlapping, in toto or in part, with an absorption peak of the first reactive gas.

Thanks to sub-step B1) above, during sub-step A1) it is possible to ramp and maintain the temperature of the reaction chamber to 800 - 1100°C. In the absence of sub-step B1) it may have been necessary to operate at higher temperatures. The lower temperature allows to better stabilize the carbon products, thereby improving carbon etching and providing energy savings.

The inventors have observed that the molar concentration of the first reactive gas into the carrier gas should be equal to 15 - 40%. Surprisingly, by selecting this concentration, under the temperature and pressure conditions set forth above, it is possible to remove the parasitic SiC deposits without detriment to the coated/uncoated graphite parts concerned. The removal of the parasitic SiC deposits is not necessarily conducted until reaching 100% removal. Advantageously, deposits may be removed to a degree suitable to recreate adequate operating conditions inside the reaction chamber, thereby extending operation time in between PM operations.

However, under the process conditions laid out in the present disclosure, and thanks to UV photon assisted approach, the method according to the invention allows a suitable removal of both carbon and Si of the parasitic SiC deposits. The removal is adequate for the purpose of resuming deposition operations, thereby extending the operating lifetime of a reaction chamber between successive PMs.

The SiC film referred to above and in the following may be directly obtained or obtainable as parasitic deposition of SiC on reaction chamber parts during the epitaxial deposition process of SiC layers on a rotating substrate inside said reaction chamber.

The SiC film comprises silicon carbide in polycrystalline and/or amorphous form. It will typically comprise or consist of a mixture of both polycrystalline and amorphous SiC, for example a mixture of 20 - 60% of amorphous SiC and 40-80% of polycrystalline SiC.

The amount of amorphous SiC in the film may be subject to significant local and absolute variations, according to the parasitic nature of the film.

Conversely, the SiC layers deposited on the substrate are usually monocrystalline. They are typically, though not exclusively, 3C, 4H or 6H SiC polytypes. The layers may be one or more in number.

The parasitic SiC deposits are well-known undesired by-products of the monocrystalline SiC layer deposition.

The parasitic SiC deposits occur on the surface of all parts of the reaction chamber exposed to the gas flow of SiC precursors, and especially at the upstream end of the chamber (i.e., where the precursor gases enter the reaction chamber), as well as on the elements in proximity or in contact with the substrate. They do not occur on the rotating substrate when the reaction chamber operates at nominal conditions.

In particular, the parasitic deposition occurs on removable and fixed parts of the reaction chamber (covers, rings, walls), whether stationary or rotating, as the result of their exposure to SiC precursor gases during the epitaxial deposition process. These parts are not made of silicon carbide; they are often made of material with a much lower hardness, such as graphite, optionally coated to improve mechanical resistance or hinder contamination of the reaction chamber.

The parasitic deposition of SiC is a phenomenon particularly, though not exclusively, impacting hot-walls reaction chambers. The high temperatures of the walls and of the other parts of the reaction chamber boosts this undesired phenomenon.

For clarity, here and in the following, the expression "SiC film" shall be deemed equivalent to "parasitic SiC film" or "parasitic SiC deposits," unless otherwise specified, and will refer to SiC in polycrystalline and/or amorphous form, and typically to a mixture of both.

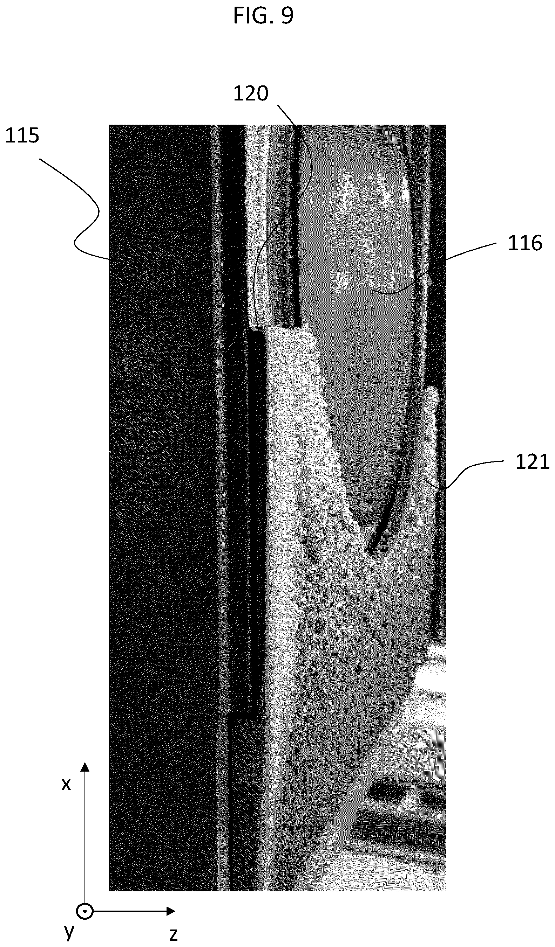

Furthermore, the term "film" in the expression "SiC film" or "silicon carbide film" shall not imply a bi-dimensional regular and/or orderly geometry. On the contrary, it refers to an uneven SiC coating formed on one or more surfaces of impacted parts of the reaction chamber and exhibiting a three-dimensional structure, or a rough gritty surface, as in the example provided in FIG. 9 and discussed further below. The parasitic silicon carbide film is the inevitable result of uncontrolled growth on reaction chamber parts during the epitaxial SiC layer deposition on a rotating substrate.

The term "film" and "layer" are used here and in the following to respectively distinguish the undesired parasitic SiC deposits (film) from the desired, controlled and typically monocrystalline SiC layers deposited on a substrate.

In general, the parasitic SiC film exhibits an uneven surface, for instance with apparent rugosity and variable thickness. The unevenness of the surface, often clearly visible to the naked eye, is usually, but not necessarily accompanied by a cauliflower- or fractal-like structure, with visible macroscopic dips and protrusions, possibly due to a dendritic-like growth process.

This phenomenon is especially visible and affecting the quality of deposited layers when the reaction chamber runs for 100 µm to 2000 µm of total monocrystalline SiC deposition (on one same substrate or on a plurality of consecutively treated substrates without a PM cycle in between), for instance when it runs for 100 - 800 µm of total monocrystalline SiC deposition.

In the case above, the parasitic growth can be etched in a particularly satisfactory manner with the present method.

FIG. 9 shows the parasitic SiC film 121 on the part 120 of a reaction chamber, positioned on the bottom wall of the chamber 115. The part 120, which is an upstream cover, partially surrounds a receiving area 116 adapted to host a 6" substrate. The parasitic SiC deposit appears lighter in color in the grayscale picture compared to the other visible parts of the reaction chamber, which are made of graphite. The parasitic deposit 121 coats the surface of the part 120 exposed to precursor gases with an uneven, granular, and gritty film.

These irregular features of the parasitic film become more pronounced as the reaction chamber part is exposed to the flow of precursor gases.

After the first step (i), the method of the invention may comprise an optional purging step of the reaction chamber, as set forth in block 20. This step comprises the execution of 1 - 20 cycles of a purging process, which may clean the reaction chamber from the remnants of the other operations/processes carried out therein.

During the purging process the following sub-steps (block 21 and 22 of FIG. 1) are sequentially executed starting from either of them:
- adjusting the pressure of the reaction chamber to ≤ 1 mbar; and
- flowing an inert gas to reach a pressure of 100 - 1000 mbar inside the reaction chamber.

The optional cooling step C), which may be performed after step B), comprises the sub-steps of:
C1) cooling the reaction chamber to a temperature below 1000 °C (block 71), preferably at a temperature between 500 - 900 °C; and
C2) flowing a cooling gas to reach a pressure of 100 - 1000 mbar inside the reaction chamber (block 72).

Sub-steps C1 and C2 may be performed in any order, including simultaneously.

Sub-step C1 may be performed by turning off the heating system and allowing the reaction chamber to cool, mainly by radiation. Sub-step C1 and sub-step C2 may run simultaneously to expedite the cooling step.

The cooling gas employed in sub-step C2 may be any gas suitable to favor the cooling process of the chamber to idle temperature, at 500 - 900 °C. The person with average skill in the art might easily select the most suitable gas depending on budget and time constraints. Non-limiting examples of cooling gases include helium, nitrogen, hydrogen, and combinations thereof.

After step B), before or after the optional step C) if present, it may be beneficial to optionally execute 1 - 20 cycles of the purging process hereinbefore described (block **20),** thus removing all traces of the reactive gases used, as well as any by-products of the etching process that may be still present in the chamber.

The cooling step C) may be advantageously used to set up favorable conditions to execute said further optional purging process. Conversely, the latter may help achieve the effects of the cooling step C) more efficiently, depending on the order in which they are executed.

In conclusion, the optional purging process may be executed after step B) and before step C) as an additional step of the etching process, or after both step B) and C) once the etching process is concluded.

With great advantage, the method above described can be used for the *in-situ* and *ex-situ* etching of SiC films from one or more parts of a reaction chamber.

For what concerns the *in-situ* etching applications, the possibility of chemically cleaning the reaction chamber after parasitic build-up and to set it in adequate operating conditions without the need to: (a) open the reactor, (b) remove the reaction chamber, and (c) expose its parts to air for cleaning, is a considerable improvement with respect to the current mechanical cleaning techniques.

Surprisingly, despite the unique and challenging properties of SiC, it is possible to effectively remove up to hundreds of microns of hard, disorderly parasitic deposits without damaging the parts of the reaction chamber.

The above method answers the long-felt need in the industry of providing a method for *in-situ* cleaning the reaction chamber of a SiC reactor from parasitic deposits.

Under an embodiment, the flow rate of the at least first reactive gas is 5 - 15 slm (standard liter per minute). Preferably the flow rate of the at least first reactive gas is > 5 slm and < 15 slm.

Under an embodiment, the light source has at least one emission peak in the UV region overlapping, in toto or in part, with an absorption peak of the first reactive gas.

When the first reactive gas has a plurality of absorption peaks in the UV region, it is convenient to select a light source overlapping, in toto or in part, with the main absorption peak.

If the halogen gas is Cl₂, for example, it may be convenient to select a light source having at least one emission peak at 310 - 370 nm, preferably at 330-360 nm.

Under an embodiment, the intensity of the light source may roughly correspond to 5 10¹⁶ - 5 10 ¹⁷photons/s/cm² at 310 - 370 nm, preferably at 330-360 nm

Under an embodiment, the at least one light source is a mercury UV lamp. These lamps are typically built as tubes. They can be easily customized to optimize the illumination of the reactive gas flow. Furthermore, mercury lamps may be advantageously doped with Fe, Co, Ga and/or In, including Ga-In, to maximize emission in the desired spectral region, i.e., in proximity to the UV absorption peak of the first reactive gas.

The light source may have a power of 2-8 kW.

Under an embodiment, the reactor is provided with at least one optical device, such as a reflective element or a concentrator (reflective or refractive), suitable to redirect the light from the light source onto the reactive gas flow.

The above optical device may be receiving light coming directly and/or indirectly from the light source. In the latter case it may receive, or be configured to receive, light originated from the light source and then reflected, refracted, diffracted, scattered and/or diffused from the surrounding environment and from the first reactive gas flow. The optical device may be advantageously oriented in a way to maximize overlap between the redirected light and the reactive gas flow.

Under an embodiment, the SiC film is obtained as by-product of one or more epitaxial deposition processes of monocrystalline SiC layers on a rotating substrate, where said process is executed in the reaction chamber of a reactor; said by-product being formed on one or more parts of said reaction chamber.

It is noted that the technical properties of the SiC film imparted by the parasitic build up process are adequately defined only in terms of the parasitic process per se. While the latter certainly imparts recognizable features, such as unevenness and rugosity of the film, it would be unduly limiting to characterize the SiC film in terms of said features.

Under an embodiment, step (i) of the method according to the invention is performed by executing one or more cycles of epitaxial deposition of monocrystalline SiC layers inside a reaction chamber of a reactor, until reaching a predefined total thickness T of layers deposited on one or more consecutive substrates, where T is preferably 100 µm - 2 mm, even more preferably 200 - 800 µm, even more preferably 500 - 700 µm.

During this step, a parasitic SiC film of variable and uneven thickness is formed on one or more parts of the reaction chamber. The SiC film thus obtained is said to have an "equivalent thickness" T, where T is the predefined total thickness T discussed above.

It is noted that the actual local thickness of the parasitic film may greatly vary within the reaction chamber, and may differ on average from T.

It is noted that the peaks of the parasitic film may be significantly higher than the thickness T, because of the dendritic-like growth of the film.

Under an embodiment, the etching process of the method according to the invention is executed for 0,12 - 0,24 minutes per µm of equivalent thickness T.

As previously discussed, in the art the equivalent thickness of a parasitic film coincides with the thickness of the monocrystalline layers deposited on one or more substrates during one or more consecutive deposition processes (without PM). As the orderly monocrystalline layers grow on the substrate(s), the parasitic film grows on certain parts of the reaction chamber, with variable height. It is therefore more meaningful to refer to its equivalent thickness, which is a parameter set and controlled during the reactor operation, and which can be easily measured on the actual substrates after the deposition process.

The silicon carbide film of the invention may exhibit a surface roughness greater than 6,3 µm Ra, and can be easily distinguished from any SiC preventively coated parts, the latter typically having a surface roughness much lower than 6,3 µm Ra.

Under an embodiment, if the first reactive gas is a halogen compound, the compound is a hydrogen halide.

Under an embodiment, if the first reactive gas is a halogen compound, the halogen compound is not a metal halide, an interhalogen compound, an organohalogen compound, nor a polyhalogenated compound.

Under an embodiment, the first reactive gas is chosen from the group consisting of F₂, ClF, ClF₃, ClF₅, Cl₂, HCl, XeF₂, XeF₄, XeF₆, XeO₃, KrF₂, Br₂, I₂, and HBr.

Under an embodiment, the first reactive composition used in step B) further comprises a second reactive gas.

Under an embodiment, said second reactive gas is an oxidizing or a reducing agent.

A non-limiting example of reducing agent is H₂.

By oxidizing agent, it is meant an oxygen compound, an oxygen molecule, or an oxygen radical.

Here and in the following, examples of oxidizing agents that have been observed to work particularly well in the execution of the invention are: N₂O, NO, N₂O₂, O₂, O₃, and H₂O₂.

Under an embodiment, the first reactive gas and the second reactive gas in the first reactive composition are respectively chosen from the group consisting of the pairs: HCl and N₂O, HCl and O₃, HCl and H₂O₂, HCl and O₂, Cl₂ and O₂, Cl₂ and O₃, Cl₂ and H₂O₂, HCL and H₂, and HCl and HF.

Under an embodiment, step B includes the following sub-steps:
B3. optionally exposing a second reactive composition to the at least one light source, and
B4. delivering the second reactive composition into the reaction chamber, said second reactive composition includes one or more reactive gases and a carrier gas, wherein the carrier gas is an inert gas, and wherein the one or more reactive gases comprise at least a third reactive gas, wherein the third reactive gas includes a halogen, a halogen compound, or an oxidizing agent.

For example, the second reactive composition may include a halogen or halogen compound chosen from the group consisting of F₂, ClF, ClF₃, ClF₅, Cl₂, HCl, XeF₂, XeF₄, XeF₆, XeO₃, KrF₂, Br₂, I₂, and HBr.

For example, the second reactive composition may include an oxidizing agent chosen from the group consisting of N₂O, NO, N₂O₂, O₂, O₃, and H₂O₂.

For example, the second reactive composition may include a halogen or halogen compound and an oxidizing agent.

For example, the second reactive composition may include the following pairs: HCl and N₂O, HCl and O₃, HCl and H₂O₂, HCl and O₂, Cl₂ and O₂, Cl₂ and O₃, Cl₂ and H₂O₂, HCL and H₂, and HCl and HF.

Under an embodiment the first reactive composition and the second reactive composition comprise any of the following combinations, hereinafter listed as (first reactive composition) + (second reactive composition) for conciseness:
(F2) + (HCl and N2O), (F2) + (HCl and O3), (F2) + (HCl and H2O2), (F2) + (HCl and O2), (F2) + (Cl2 and O2), (F2) + (Cl2 and O3), (F2) + (Cl2 and H2O2), (F2) + (HCL and H2), (F2) + (HCl and HF), or [0193] (ClF) + (HCl and N2O), (ClF) + (HCl and O3), (ClF) + (HCl and H2O2), (ClF) + (HCl and O2), (ClF) + (Cl2 and O2), (ClF) + (Cl2 and O3), (ClF) + (Cl2 and H2O2), (ClF) + (HCL and H2), (ClF) + (HCl and HF), (ClF3) + (HCl and N2O), (ClF3) + (HCl and O3), (ClF3) + (HCl and H2O2), (ClF3) + (HCl and O2), (ClF3) + (Cl2 and O2), (ClF3) + (Cl2 and O3), (ClF3) + (Cl2 and H2O2), (ClF3) + (HCL and H2), (ClF3) + (HCl and HF), (ClF5)+(HCl and N2O), (ClF5)+(HCl and O3), (ClF5) + (HCl and H2O2), (ClF5) + (HCl and O2), (ClF5) + (Cl2 and O2), (ClF5) + (Cl2 and O3), (ClF5) + (Cl2 and H2O2), (ClF5) + (HCL and H2), (ClF5) + (HCl and HF), (Cl2) + (HCl and N2O), (Cl2) + (HCl and O3), (Cl2) + (HCl and H2O2), (Cl2) + (HCl and O2), (Cl2) + (Cl2 and O2), (Cl2) + (Cl2 and O3), (Cl2) + (Cl2 and H2O2), (Cl2) + (HCL and H2), (Cl2) + (HCl and HF), (HCl) + (HCl and N2O), (HCl) + (HCl and O3), (HCl) + (HCl and H2O2), (HCl) + (HCl and O2), (HCl) + (Cl2 and O2), (HCl) + (Cl2 and O3), (HCl) + (Cl2 and H2O2), (HCl) + (HCL and H2), (HCl) + (HCl and HF), (XeF2) + (HCl and N2O), (XeF2) + (HCl and O3), (XeF2) + (HCl and H2O2), (XeF2) + (HCl and O2), (XeF2) + (Cl2 and O2), (XeF2) + (Cl2 and O3), (XeF2) + (Cl2 and H2O2), (XeF2) + (HCL and H2), (XeF2) + (HCl and HF), (XeF4) + (HCl and N2O), (XeF4) + (HCl and O3), (XeF4) + (HCl and H2O2), (XeF4) + (HCl and O2), (XeF4) + (Cl2 and O2), (XeF4) + (Cl2 and O3), (XeF4) + (Cl2 and H2O2), (XeF4) + (HCL and H2), (XeF4)+(HCl and HF), (XeF6) + (HCl and N2O), (XeF6) + (HCl and O3), (XeF6) + (HCl and H2O2), (XeF6) + (HCl and O2), (XeF6) + (Cl2 and O2), (XeF6) + (Cl2 and O3), (XeF6) + (Cl2 and H2O2), (XeF6) + (HCL and H2), (XeF6) + (HCl and HF), (XeO3) + (HCl and N2O), (XeO3) + (HCl and O3), (XeO3) + (HCl and H2O2), (XeO3) + (HCl and O2), (XeO3) + (Cl2 and O2), (XeO3) + (Cl2 and O3), (XeO3) + (Cl2 and H2O2), (XeO3) + (HCL and H2), (XeO3) + (HCl and HF), (KrF2) + (HCl and N2O), (KrF2) + (HCl and O3), (KrF2) + (HCl and H2O2), (KrF2) + (HCl and O2), (KrF2) + (Cl2 and O2), (KrF2) + (Cl2 and O3), (KrF2) + (Cl2 and H2O2), (KrF2) + (HCL and H2), (KrF2) + (HCl and HF), (Br2) + (HCl and N2O), (Br2) + (HCl and O3), (Br2) + (HCl and H2O2), (Br2) + (HCl and O2), (Br2) + (Cl2 and O2), (Br2) + (Cl2 and O3), (Br2) + (Cl2 and H2O2), (Br2) + (HCL and H2), (Br2) + (HCl and HF), (I2) + (HCl and N2O), (I2) + (HCl and O3), (I2) + (HCl and H2O2), (I2) + (HCl and O2), (I2) + (Cl2 and O2), (I2) + (Cl2 and O3), (I2) + (Cl2 and H2O2), (I2) + (HCL and H2), (I2) + (HCl and HF), (HBr) + (HCl and N2O), (HBr) + (HCl and O3), (HBr) + (HCl and H2O2), (HBr) + (HCl and O2), (HBr) + (Cl2 and O2), (HBr) + (Cl2 and O3), (HBr) + (Cl2 and H2O2), (HBr) + (HCL and H2), (HBr) + (HCl and HF), (HCl and N2O) + (HCl and N2O), (HCl and N2O) + (HCl and N2O), (HCl and N2O) + (HCl and O3), (HCl and N2O) + (HCl and H2O2), (HCl and N2O) + (HCl and O2), (HCl and N2O) + (Cl2 and O2), (HCl and N2O) + (Cl2 and O3), (HCl and N2O) + (Cl2 and H2O2), (HCl and N2O) + (HCL and H2), (HCl and N2O) + (HCl and HF), (HCl and O3) + (HCl and N2O), (HCl and O3) + (HCl and O3), (HCl and O3) + (HCl and H2O2), (HCl and O3) + (HCl and O2), (HCl and O3) + (Cl2 and O2), (HCl and O3) + (Cl2 and O3), (HCl and O3) + (Cl2 and H2O2), (HCl and O3) + (HCL and H2), (HCl and O3) + (HCl and HF), (HCl and H2O2) + (HCl and N2O), (HCl and H2O2) + (HCl and O3), (HCl and H2O2) + (HCl and H2O2), (HCl and H2O2) + (HCl and O2), (HCl and H2O2) + (Cl2 and O2), (HCl and H2O2) + (Cl2 and O3), (HCl and H2O2) + (Cl2 and H2O2), (HCl and H2O2) + (HCL and H2), (HCl and H2O2) + (HCl and HF), (HCl and O2) + (HCl and N2O), (HCl and O2) + (HCl and O3), (HCl and O2) + (HCl and H2O2), (HCl and O2) + (HCl and O2), (HCl and O2) + (Cl2 and O2), (HCl and O2) + (Cl2 and O3), (HCl and O2) + (Cl2 and H2O2), (HCl and O2) + (HCL and H2), (HCl and O2) + (HCl and HF), (Cl2 and O2) + (HCl and N2O), (Cl2 and O2) + (HCl and O3), (Cl2 and O2) + (HCl and H2O2), (Cl2 and O2) + (HCl and O2), (Cl2 and O2) + (Cl2 and O2), (Cl2 and O2) + (Cl2 and O3), (Cl2 and O2) + (Cl2 and H2O2), (Cl2 and O2) + (HCL and H2), (Cl2 and O2) + (HCl and HF), (Cl2 and O3) + (HCl and N2O), (Cl2 and O3) + (HCl and O3), (Cl2 and O3) + (HCl and H2O2), (Cl2 and O3) + (HCl and O2), (Cl2 and O3) + (Cl2 and O2), (Cl2 and O3) + (Cl2 and O3), (Cl2 and O3) + (Cl2 and H2O2), (Cl2 and O3) + (HCL and H2), (Cl2 and O3) + (HCl and HF), (Cl2 and H2O2) + (HCl and N2O), (Cl2 and H2O2) + (HCl and O3), (Cl2 and H2O2) + (HCl and H2O2), (Cl2 and H2O2) + (HCl and O2), (Cl2 and H2O2) + (Cl2 and O2), (Cl2 and H2O2) + (Cl2 and O3), (Cl2 and H2O2) + (Cl2 and H2O2), (Cl2 and H2O2) + (HCL and H2), (Cl2 and H2O2) + (HCl and HF), (HCL and H2) + (HCl and N2O), (HCL and H2) + (HCl and O3), (HCL and H2) + (HCl and H2O2), (HCL and H2) + (HCl and O2), (HCL and H2) + (Cl2 and O2), (HCL and H2) + (Cl2 and O3), (HCL and H2) + (Cl2 and H2O2), (HCL and H2) + (HCL and H2), (HCL and H2) + (HCl and HF), (HCl and HF) + (HCl and N2O), (HCl and HF) + (HCl and O3), (HCl and HF) + (HCl and H2O2), (HCl and HF) + (HCl and O2), (HCl and HF) + (Cl2 and O2), (HCl and HF) + (Cl2 and O3), (HCl and HF) + (Cl2 and H2O2), (HCl and HF) + (HCL and H2), or (HCl and HF) + (HCl and HF).

Under an embodiment, the etching process of the method according to the invention further comprises a monitoring step (block 60) and the reaction chamber 100 comprises at least one monitoring system 500 adapted to monitor an etching parameter indicative of an endpoint of the etching process.

The monitoring step is executed at the end of step B) and comprises the following sub-steps:
- reading a preset target value of the etching parameter (62), and optionally a preset tolerance;
- reading the actual value of the etching parameter (61);
- checking if the actual value has reached the target value (63), optionally within said preset tolerance;
- repeating step B) until reaching said target value (optionally within said preset tolerance).

Once the target value is achieved, the monitoring step is concluded, and no more cycles of the etching process are performed.

The monitoring system may be a detector suitable to detect the concentration of silicon and/or carbon in the by-product gases generated after each cycle of the etching step B), such as a mass spectrometer.

Advantageously, this embodiment allows to monitor the progress of the method according to the invention.

For example, the monitoring step depicted in FIG. 3 may be carried out according to the block diagram of FIG. 4, though the sequence of blocks 61 and **62** may be exchanged.

Under an embodiment, the method according to the invention is executed *in-situ* to etch the silicon carbide film from one or more parts of a reaction chamber, i.e., the method is executed when the reaction chamber is positioned inside the reactor and without opening the latter. To this effect, the reaction chamber may be provided with at least one gas inlet and at least one gas outlet.

In this case, the light source is positioned upstream of the gas inlet. Therefore, during step B) the first reactive composition flow is exposed to the UV photons emitted by the light source before entering the reaction chamber. The first reactive composition is then delivered into the reaction chamber through the at least one gas inlet. Radicals or ions of the first reactive gas are created (a) before entering the reaction chamber, because of the UV radiation, and (b) inside the reaction chamber, because of the temperature and pressure conditions.

The chemical etching of parasitic SiC films takes place inside the reaction chamber, generating by-products of the etching process. These by-products may be discharged through the at least one gas outlet.

Advantageously, the *in-situ* cleaning of the reaction chamber parts allows drastically reducing PM times and the exposure of operators to the reaction chamber. Said exposure represents an EHS concern that requires elaborate and time-consuming safety procedures.

Preferably but not exclusively, the reaction chamber of the present embodiment is an epitaxial reaction chamber.

According to the above embodiment, the invention relates to a method for *in-situ* etching a SiC film from one or more parts of a reaction chamber for the deposition of monocrystalline silicon carbide layers on a substrate, where the reactor is equipped with at least one light source adapted to emit light in correspondence to an absorption peak of the first reactive gas. The method comprises the steps of:
(i) providing a silicon carbide film on one or more parts of a reaction chamber of a reactor for deposition silicon carbide; wherein said reaction chamber is equipped with at least one gas inlet and at least one gas outlet;
(ii) executing at least one cycle of an etching process comprising the steps of:
   A) ramping the reaction chamber to preset etching process conditions;
   B) etching the silicon carbide film.

Step A comprises the sub-steps of: A1) adjusting the temperature of the reaction chamber to 800 - 1450 °C, preferably to 800 - 1100 °C; and A2) adjusting the pressure of the reaction chamber to 50 - 1000 mbar, preferably 150 - 700 mbar.

Step B) comprises the sub-steps of: B1) exposing a first reactive composition to the light source; and B2) delivering a first reactive composition into the reaction chamber through the gas inlet; where said first reactive composition comprises one or more reactive gases and a carrier gas.

The carrier gas is an inert gas. The one or more reactive gases comprise at least a first reactive gas, which is halogen or a halogen compound, and the molar concentration of the first reactive gas into the carrier gas is 15 - 40%.

Advantageously, the method according to the invention allows to reach a removal rate of the silicon carbide film of 0.01 - 0.20 g/cm² per hour, without affecting the underlying parts of the reaction chamber. This parameter may be measured during calibration of the method by weighting the affected parts before and after deposition, and before and after etching.

In one embodiment, these parts may comprise the upper and lower walls of the chamber, and/or the covers (upstream and/or downstream) of said walls, as well as rings, and other elements of the reaction chamber.

Under an embodiment, the reaction chamber 100 of the method according to the invention is of the hot-wall type, and the one or more parts of the reaction chamber to be etched are made of graphite, optionally provided with a coating comprising or consisting of a silicon carbide, pyrolytic graphite, pyrolytic carbon, polycrystalline diamond, monocrystalline diamond, quartz, and/or boron nitride.

The silicon carbide coating of the above embodiment will typically exhibit a rugosity much lower than that of parasitic SiC films.

Typically, said coating will have a rugosity < 6,3 µm Ra, preferably < 1 µm Ra, and usually exhibit a mono- or poly-crystalline structure.

The parasitic SiC films have been observed to grow both over bare graphite and over graphite covered with the above-mentioned coatings.

The method hereinbefore described has been observed to work well with reaction chambers for the deposition of silicon carbide.

For example, without limitation, the reaction chamber may be of the type described in international patent applications published as: WO2004053187, WO2004053188, WO2007088420 and WO2015092525.

For example, without limitation, the reaction chamber may be of the type described in US patent application No.18/953,993.

These designs are affected by parasitic build-up on graphite workpieces. The parasitic build-up occurs on graphite parts that are critical to preserve.

The method according to the invention is effective against parasitic SiC build-up, without damaging the graphite parts underneath, thanks to the specific process conditions herein disclosed. Preferably, but not exclusively, the method according to the invention may be executed when the reaction chamber is of the hot-wall, epitaxial, horizontal, and/or crossflow type.

In any event the present invention is not limited to a specific reaction chamber design.

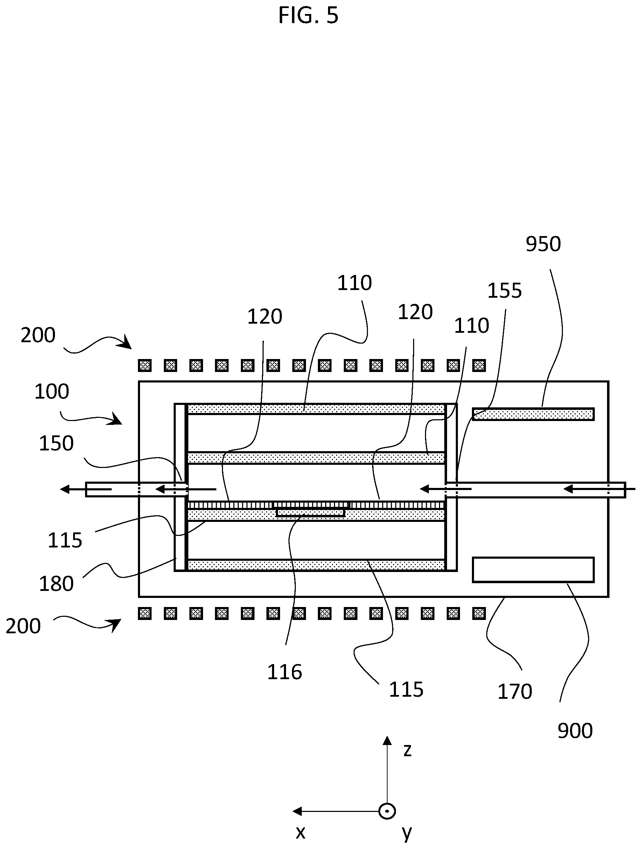

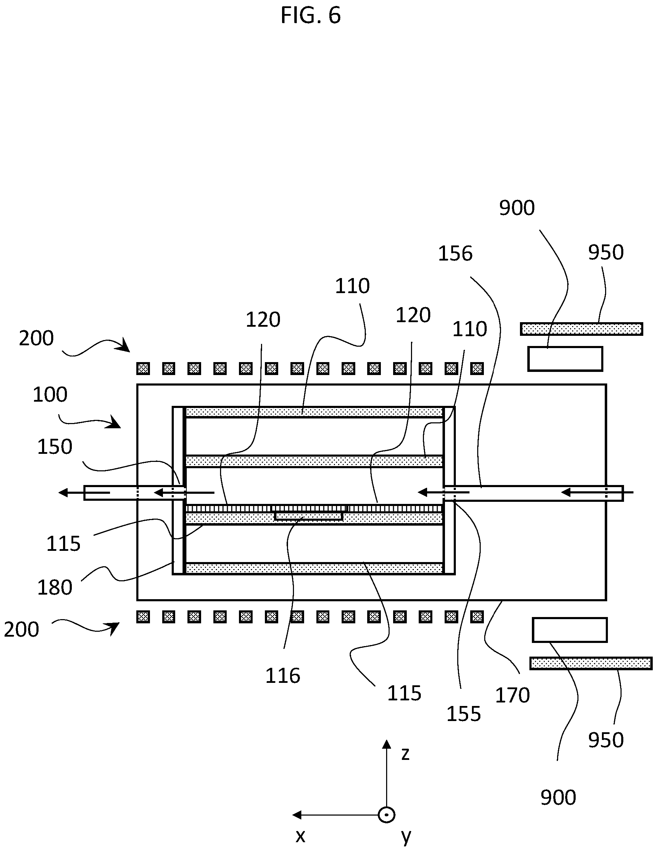

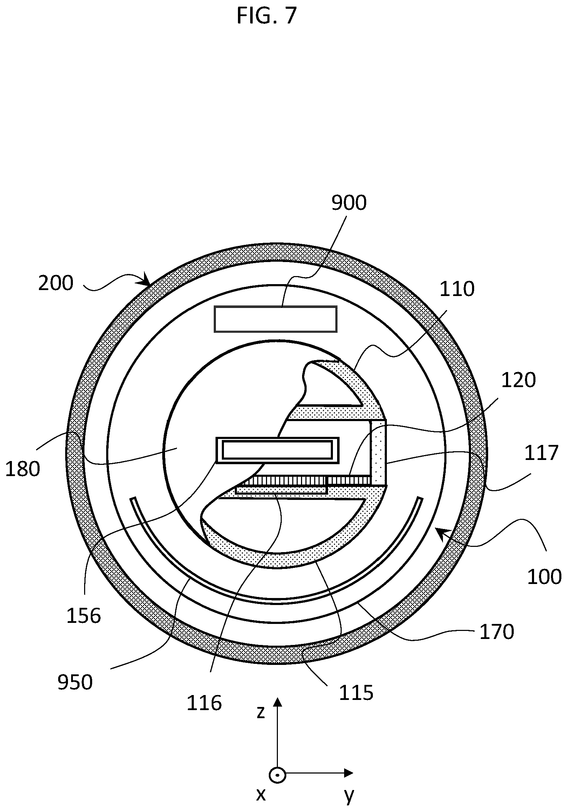

By way of non-limiting example, in reference to FIG. 5, FIG. 6 and FIG. 7, the reaction chamber 100 is configured for the epitaxial deposition of SiC and extends along a longitudinal direction x. The chamber may comprise an inlet 155 and an outlet 150 adapted to flow process gases, purging gases, cooling gases, and first reactive compositions into and out of the reaction chamber and over a receiving area 116.

The receiving area is adapted to receive a substrate on a substrate holder. It may be a recess configured to position a substrate holder.

The receiving area may be adapted to rotate the substrate holder during the SiC deposition process.

The chamber may be further equipped with suitable injectors, liners, nozzles, shower heads to favor the entrance and discharge of any and all gases above.

The chamber 100 may have a circular or oval cross section in a transverse plane **yz** perpendicular to the longitudinal direction **x.** The chamber may comprise an upper half-moon 110 and a lower half-moon 115, both made of graphite and separated by two lateral elements 117 made of polycrystalline SiC and having surface roughness of 0.5 - 1 µm Ra.

The chamber may comprise other parts, such as covers 120, used to protect the exposed upper surface of the bottom half-moon 115 from SiC build-up.

The reaction chamber 100 may further comprise several insulating elements, of which only element 180 is partially shown.

The reaction chamber 100 may further comprise a quartz enclosure 170. The quartz enclosure may be a double wall quartz tube optionally cooled with a cooling fluid such as water.

The reaction chamber 100 may be surrounded by a heating system, such as an induction coil 200 wrapped around the quartz enclosure 170. The coil may be configured to heat the top and lower walls 110 and **115** of the reaction chamber.

Many other variants of the above reaction chamber design may be used in the execution of the present invention.

Under a second aspect, the present invention relates to a SiC reactor 1000 adapted to perform the *in-situ* etching of silicon carbide films deposited on one or more parts a reaction chamber 100, according to any embodiments of the method 1.

The reactor 1000 comprises at least one reaction chamber **100** for the deposition of silicon carbide layers on a substrate, said reaction chamber being provided with at least one gas inlet and at least one gas outlet.

Preferably, the reactor 1000 comprises 1-10 reaction chambers, even more preferably 1-4.

The reactor is connected or connectable to a source of Si and C precursors **(1200** and **1250).** For example, the silicon precursor gas may be a chlorinated compound, preferably dichlorosilane, trichlorosilane or tetrachlorosilane. The carbon precursor gas may be a hydrocarbon, in particular propane or ethylene or acetylene or methane. Other types of precursors may be used.

Other sources, such as sources for n- and p- doping may be connected or connectable to the reactor. For instance, the n-source may be nitrogen, acetonitrile, pyrrole, ammonia, hydrazine, hydrogen cyanide, methylamine.

The reactor is also connectable or connected to a source of a first reactive composition through the gas inlet 155, so that the first reactive composition is delivered into the reaction chamber through the gas inlet.

The source of the first reactive composition may comprise a source 1100 of the carrier gas (an inert gas, preferably Ar or He) and a source 1150 of the first reactive gas. Other sources may be present, such as sources of second or third reactive gases.

With the term "source" in general it is meant a line for gas or liquid, a cylinder and/or a vessel.

The reactor 1000 further comprises a heating system 200 adapted to heat the reaction chamber to a temperature up to 1700°C, in order to perform the deposition of SiC. Specifically, in the context of the present invention, the heating system 200 should be adapted to heat the reaction chamber to a temperature of 800 - 1450 °C, preferably 800-1100 °C, in order to execute the etching process of the method according to the invention. It is understood that the actual temperature inside the chamber may differ depending on the chamber design, the heating system, and the number of substrates being treated.

The heating system may be located outside the reaction chamber, as depicted in FIG. 5 - 8, but other configurations are possible.

The reactor 1000 further comprises a light source 900 adapted to emit light in the 310-370 nm range, and preferably having an emission peak at 330-360 nm.

The light source is preferably located upstream with respect to the gas inlet.

The light source may be a UV laser, a LED or UV lamp. Preferably, the light source is a mercury UV lamp, optionally doped with Fe, Co, Ga and/or In, such as Ga-In.

The reactor 1000 may optionally comprise at least one optical device 950, such as a reflective element or a concentrator, to redirect the light from the light source onto the first reactive composition before the latter is delivered into the reaction chamber.

The reactor 1000 further comprises a vacuum system 300 adapted to bring the reaction chamber to a pressure ≤ 1000 mbar, such as between 100 - 1000 mbar. The vacuum system 300 may comprise at least one pump.

The pump is suitable for (a) depressurizing the reaction chamber 100 and/or (b) flowing exhaust gases (resulting from the deposition and etching processes, and/or or cooling steps), out of the reaction chamber through the one or more gas outlets and into a scrubber 400. The vacuum system may further comprise at least one valve, preferably a throttle valve upstream of the vacuum pump.

Advantageously, the reactor above described is adapted to execute the method 1 according to the invention, thereby achieving improved reactor downtimes due to PM.

Under an embodiment, the gas inlet 155 of the reaction chamber 100 is connected to a gas liner 156 and the light source 900 is preferably placed upstream with respect to the gas inlet and is oriented toward the gas liner. The gas liner may be advantageously made of a material essentially transparent in the 310-370 nm window. For example, the gas liner may be made of quartz.

Under an embodiment, the reactor 1000 further comprises: a processor 600, an accessible memory, and an *in-situ* etching program.

The *in-situ* etching program can be stored as a sequence of machine language instructions in the accessible memory and adapted to perform steps A and B of the etching process of the method according to the invention.

The processor 600 is configured or configurable to execute the *in-situ* etching program, for instance, by actuating controls 700. These controls operate the sources 1100 and **1150** of the reactive gas mixture.

The controls 700 may comprise a system of valves, such as throttle valves, pumps, and circuitry able to control the flow rate, timing, and absolute and relative quantity of the carrier gas and of the one or more reactive gases.

The gases used in the etching process or the SiC deposition processes may be combined before entering the reaction chamber 100. They may enter the reaction chamber in one stream. Alternatively, they may enter the reaction chamber in a plurality of streams with different concentrations and/or flow rates depending on their injection point and direction. To this effect, it is possible to use a plurality of inlets. Alternatively, it is possible to use one inlet attached to a liner provided with segregated areas to accommodate separate streams of gas flow.

The processor 600 may be configured or configurable to control the vacuum system 300, via one or more valves, such as throttle valves, and circuitry.

The reactor 1000 may optionally comprise a human-machine interface 800, to allow an end user to start the etching process, adjust the relevant parameters, and optionally follow its progress.

Under an embodiment, the reaction chamber 100 of the reactor 1000 is of the hot-wall type and comprises one or more parts made of graphite, optionally coated with monocrystalline or polycrystalline silicon carbide with a rugosity below 6,3 µm Ra, pyrolytic graphite, pyrolytic carbon, polycrystalline diamond, monocrystalline diamond, quartz, and/or boron nitride.

The heating system 200 of the reactor 1000 may be an induction system.

The reactor may be equipped with a monitoring system 500, adapted to detect/monitor an etching parameter indicative of an endpoint of the etching process and positioned between the downstream end of reaction chamber 100 (after the gas outlet 150) and the scrubber 400 where the exhaust gases are treated.

The processor 600 may be optionally configured or configurable to read and elaborate one or more signals from the monitoring system 500 if present.

The reactor according to the invention may comprise one or more detectors for the detection of one or more reactive gases, where said detectors include means to trigger an alarm or a stop signal to ensure user safety.

It is understood that the reactor according to the invention may include all other elements that are essential or desirable in a reactor, such as cabinetry, pipes, actuators, circuits, valves, pumps, powering means.

The subject matter of the present disclosure includes all novel and nonobvious combinations and sub-combinations of the various processes, systems, and configurations, and other features, functions, acts, and/or properties disclosed herein, as well as any and all equivalents thereof.

## Claims

1. A method for etching a silicon carbide film from one or more parts of a reaction chamber of a reactor for the deposition of one or more silicon carbide layers on a substrate;
wherein the reactor comprises at least one light source adapted to emit light in the 310-370 nm range;
said method comprising the steps of:
(i) providing a silicon carbide film on said one or more parts of the reaction chamber, said silicon carbide film comprising silicon carbide in polycrystalline and/or amorphous form;
(ii) executing at least one cycle of an etching process comprising the steps of:
A. ramping the reaction chamber to preset etching process conditions;
B. etching the silicon carbide film;
wherein step A comprises the sub-steps of:
A1. ramping of the reaction chamber to a temperature of 800 - 1450 °C;
A2. ramping the reaction chamber to a pressure of 100 - 1000 mbar;
wherein step B comprises the sub-step of:
B1. exposing a first reactive composition to the at least one light source; and
B2. delivering the first reactive composition into the reaction chamber; said first reactive composition comprising one or more reactive gases and a carrier gas;
wherein the one or more reactive gases comprise at least a first reactive gas;
wherein said first reactive gas is a halogen or halogen compound; and
wherein the molar concentration of the first reactive gas into the carrier gas is 15 - 40%.

2. The method according to claim 1, wherein said at least one light source has at least one emission peak in the UV region overlapping, in toto or in part, with an absorption peak of the first reactive gas.

3. The method according to claim 1 or 2, wherein the at least one light source is a mercury UV lamp optionally doped with Fe, Co, Ga and/or In.

4. The method according to any one of claims 1 to 3, wherein the reactor is provided with one or more reflective elements and/or concentrators adapted to redirect the light from the at least one light source onto the first reactive composition.

5. The method according to any one of the preceding claims, wherein the etching process further comprises a cooling step C to be executed after step B; the cooling step C comprising the following sub-steps:
C1. adjusting the temperature of the reaction chamber to a value below 1000 °C; and
C2. flowing a cooling gas at a pressure of 100 - 1000 mbar inside the reaction chamber.

6. The method according to any one of the preceding claims, further comprising the step of executing a purging process, wherein the purging process comprises the sub-steps of:
- adjusting the pressure of the reaction chamber to ≤ 1 mbar; and
- flowing an inert gas to reach a pressure of 100 - 1000 mbar inside the reaction chamber;
wherein said purging process is executed 1 - 20 times before step A and/or after step B.

7. The method according to any one of the preceding claims, wherein the carrier gas is nitrogen, argon, or helium.

8. The method according to any one of the preceding claims, wherein the flow rate of the first reactive gas is 5 - 15 slm.

9. The method according to any one of the preceding claims, wherein the silicon carbide film is obtained as by-product of one or more epitaxial deposition processes of monocrystalline silicon carbide layers on a rotating substrate executed in the reaction chamber of the reactor; said by-product being obtained on one or more parts of said reaction chamber.

10. The method according to any one of the preceding claims, wherein step (i) is performed by executing one or more epitaxial deposition cycles of monocrystalline silicon carbide layers on a same or different substrates inside a reaction chamber of a reactor, until reaching a predefined total deposited thickness T of monocrystalline silicon carbide layers deposited, where T is preferably 100 µm - 2 mm, even more preferably 200 - 800 µm.

11. The method according to any one of the preceding claims, wherein the reaction chamber comprises at least one monitoring system adapted to monitor an etching parameter indicative of an endpoint of the etching process; and
wherein the etching process further comprises a monitoring step executed at the end of step B and comprising the following sub-steps:
- reading a preset target value of the etching parameter;
- measuring the actual value of the etching parameter;
- comparing the actual value of the etching parameter against the target value;
- repeating step B until the actual value equals the target value.

12. The method according to any one of the preceding claims, wherein the one or more parts of the reaction chamber to be etched are made of graphite, optionally coated with a coating comprising or consisting of polycrystalline diamond, monocrystalline diamond, quartz, pyrolytic graphite, boron nitride, and/or silicon carbide.

13. The method according to any one of the preceding claims, wherein the first reactive composition further comprises a second reactive gas.

14. The method according to claim 13, wherein the second reactive gas is an oxidizing agent.

15. The method according to according to any of the preceding claims, wherein step B comprises the following sub-steps:
B3. exposing a second reactive composition to the at least one light source; and
B4. delivering the second reactive composition into the reaction chamber; said second reactive composition comprising one or more reactive gases and a carrier gas;
wherein the carrier gas is an inert gas; and
wherein the one or more reactive gases comprise a third reactive gas;
wherein the third reactive gas comprises a halogen, a halogen compound, an oxidizing agent, or a combination thereof.

16. The method according to claim 14 or 15, wherein the oxidizing agent is chosen from the group consisting of: N₂O, NO, N₂O₂, O₂, O₃, and H₂O

17. The method according to claim 15, wherein the third reactive gas comprises or consists of a halogen or a halogen compound, and the molar concentration of the halogen or halogen compound into the carrier gas is 15 - 40%.

18. The method according to any one of claims 1 to 17, wherein the halogen or halogen compound is chosen from the group consisting of: F₂, ClF, ClF₃, ClF₅, Cl₂, HCl, XeF₂, XeF₄, XeF₆, XeO₃, KrF₂, Br₂, I₂, and HBr.

19. A reactor for the deposition of one or more silicon carbide layers on a substrate comprising:
- at least one reaction chamber, said reaction chamber being provided with at least one gas inlet and at least one gas outlet;
- a heating system adapted to heat the reaction chamber to a temperature up to 1700°C;
- a vacuum system adapted to bring the reaction chamber to a pressure ≤ 1000 mbar, preferably between 100 - 1000 mbar;
- at least one light source adapted to emit light in the 310-370 nm range;
wherein said reactor is configured to perform the method according to any of the preceding claims; and
wherein said at least one gas inlet is connectable to a source of the one or more reactive gases and the carrier gas; and
wherein at least one gas outlet is configured to discharge the by-products of the etching process.

20. The reactor according to claim 19, wherein said at least one gas inlet is connected to a gas liner made of quartz and the at least one light source is placed upstream with respect to the gas inlet and is oriented toward said gas liner.
